# EUROPÄISCHE PATENTSCHRIFT

(11) **EP 1 320 692 B1**
(45) Veröffentlichungstag und Bekanntmachung des Hinweises auf die Patenterteilung: **05.07.2006**
(21) Anmeldenummer: 01980168.7
(22) Anmeldetag: 17.09.2001
(51) Int. Cl.: F16C 35/077, F16C 19/00, G01N 24/08, G01R 33/28, A61B 5/055

(54) **KERNSPINTOMOGRAPH**
NMR TOMOGRAPH
TOMOGRAPHE A RESONANCE MAGNETIQUE NUCLEAIRE

(30) Priorität: 28.09.2000 DE 10048192
(43) Veröffentlichungstag der Anmeldung: 25.06.2003
(73) Patentinhaber: SIEMENS AKTIENGESELLSCHAFT, 80333 München (DE)
(72) Erfinder: SEUFERT, Matthias, 91097 Oberreichenbach (DE)
(86) Internationale Anmeldenummer: PCT/DE2001/003583
(87) Internationale Veröffentlichungsnummer: WO 2002/027203

(56) Entgegenhaltungen:
- EP-A- 0 562 865
- WO-A-98/46983
- DE-A- 3 922 279
- US-A- 2 992 868
- US-A- 5 439 297
- PATENT ABSTRACTS OF JAPAN vol. 1998, no. 06, 30. April 1998 (1998-04-30) & JP 10 037949 A (NTN CORP), 13. Februar 1998 (1998-02-13)

## Beschreibung

Die Erfindung betrifft einen Kernspintomographen wit einem Wälzlager.

Viele Komponenten eines Kernspintomographen sollen möglichst nichtmagnetisch sein, damit ein für eine kernspintomographische Untersuchung hergestelltes magnetisches Feld nicht von einem zusätzlichen magnetischen Feld überlagert wird. Deshalb werden beispielsweise für die Laufrollen eines Patiententisches des Kernspintomographen nichtmagnetische Wälzlager verwendet, dessen Wälzkörper aus Keramik und dessen Innen- und Außenringe, zwischen denen die Wälzkörper abrollen, aus nichtmagnetischem und gehärtetem Stahl ausgeführt sind. Solche Wälzlager sind jedoch teuer herzustellen. Nichtmagnetische, für Kernspintomographen geeignete Wälzlager werden beispielsweise von der INA Wälzlager Schaeffler KG hergestellt, wie deren technischer Produktinformation TPI 41, erschienen April 1995, zu entnehmen ist.

Aus der EP 0 562 865 A1 ist ein Kernspintomograph bekannt, mit dem Proben untersucht werden können. Für deren Untersuchung ist ein rotierbarer Probenhalter in einem seinerseits rotierbaren Gehäuse vorgesehen. Sowohl der Probenhalter als auch das Gehäuse sind in Wälzlagern aus nicht-magnetischem Material gelagert.

Auf Seite 40 des Hauptkatalogs 94/96 der Räder- und Rollenfabrik Rädler-Vogel, Sperlsdeicher Weg 19-23, 21109 Hamburg, sind beispielsweise Laufrollen für die Fördertechnik offenbart. Die Laufrollen sind aus einem Spezialmaterial gefertigt und umgeben ein Spezialkugellager.

Des weiteren ist aus der DE 1 892 000 U eine Laufrolle an Fahrzeugtüren bekannt. In der aus Kunststoff bestehenden Laufrolle ist ein Kugellager hineingedrückt.

Der Erfindung liegt daher die Aufgabe zugrunde, einen Kernspintomographen mit einem Wälzlager anzugeben, wobei die Fertigungskosten des Wälzlagers geringer sind und seine räumliche Ausdehnung kleiner ist.

Nach der Erfindung wird diese Aufgabe gelöst durch einen Kernspintomographen mit einem Wälzlager mit magnetischen Wälzkörpern.

Nach einer Variante der Erfindung sind die Wälzkörper von einem Innen- und einem Außenring umgeben, zwischen denen sie abrollen, wobei der Außenring von einem nichtmagnetischen Ring umgeben ist. Als Wälzkörper werden somit konventionelle magnetische Wälzkörper verwendet, die in großen Stückzahlen und somit kostengünstig hergestellt werden können.

Der nichtmagnetische Ring kann gemäß Varianten der Erfindung nichtmagnetischen Stahl, nichtmagnetisches Messing und/oder nichtmagnetisches Kupfer aufweisen.

Um die Fertigungskosten bei der Herstellung eines erfindungsgemäßen Wälzlagers gering zu halten, ist bei einer Ausführung der Erfindung vorgesehen, den Außenring in den nichtmagnetischen Ring einzupressen.

Wenn nach einer weiteren Variante der Erfindung der Innenring und/oder der Außenring magnetisch sind, können die Fertigungskosten weiter gesenkt werden. Magnetische Wälzlager mit magnetischen und gehärteten Wälzkörpern, Innen- und Außenringen können außerdem bei gleicher Tragzahl wesentlich kleiner ausgeführt werden als nichtmagnetische Wälzlager mit keramischen Wälzkörpern. Somit kann gemäß einer besonders bevorzugten Ausführungsform der Erfindung der Außendurchmesser des nichtmagnetischen Ringes wenigstens 1,5-mal größer als der Außendurchmesser des Außenringes ausgeführt werden. Folglich ist die räumliche Ausdehnung der magnetischen Komponenten des erfindungsgemäßen Wälzlagers klein und das von den magnetischen Komponenten hervorgerufene magnetische Feld wirkt sich, wenn überhaupt, dann kaum störend auf die Funktionsweise des Kernspintomographen aus.

Weitere Varianten der Erfindung sehen vor, dass das Wälzlager ein Kugellager oder ein zweireihiges Kugellager ist.

Eine Ausführungsform der Erfindung sieht vor, dass.die Wälzkörper kugelförmig sind und einen Durchmesser zwischen 3mm und 8mm und der nichtmagnetische Ring einen Außendurchmesser zwischen 55mm und 65mm aufweisen.

Die Aufgabe wird auch gelöst durch eine Verwendung eines Wälzlagers mit magnetischen Wälzkörpern in einem Kernspintomographen. Ein solches Wälzlager ist kostengünstiger herstellbar als ein nichtmagnetisches Wälzlager, wodurch die Herstellungskosten des Kernspintomographen reduziert werden.

Weitere Vorteile ergeben sich aus den Unteransprüchen.

Ausführungsbeispiele der Erfindung sind in den beigelegten schematischen Zeichnungen dargestellt. Es zeigen:
- Fig. 1: ein konventionelles nichtmagnetisches Wälzlager,
- Fig. 2: ein erfindungsgemäßes Wälzlager, und
- Fig. 3: einen Kernspintomographen mit einem erfindungsgemäßen Wälzlager.

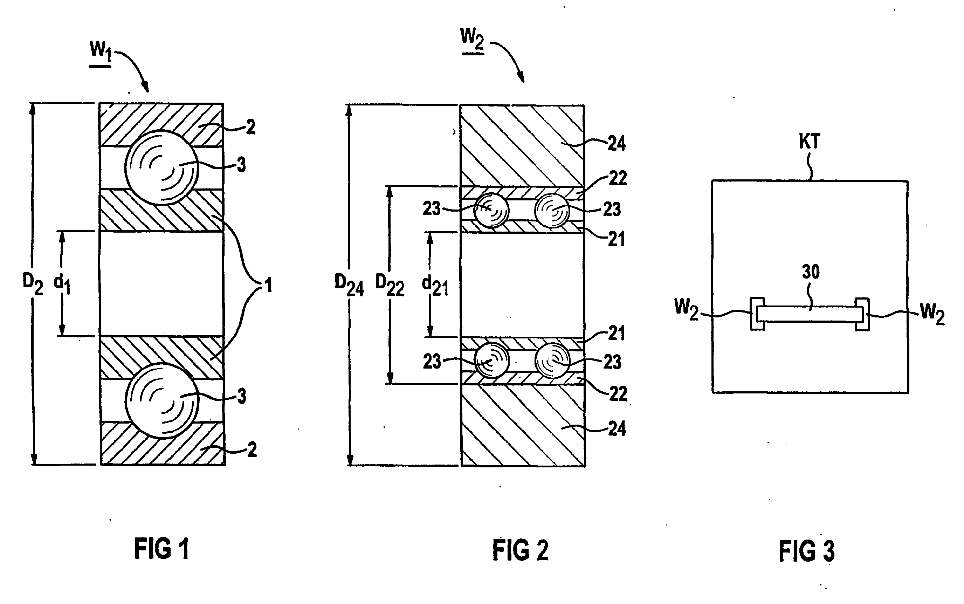

Die Fig. 1 zeigt schematisch ein Schnittbild eines konventionellen magnetischen Wälzlagers W₁ für einen Kernspintomographen. Das in der Fig. 1 gezeigte Wälzlager W₁ ist als ein Kugellager ausgeführt.

Das Wälzlager W₁ weist einen Innenring 1 und einen Außenring 2 auf, die z. B. aus nichtmagnetischem und gehärtetem Stahl ausgeführt sind. Zwischen dem Innenring 1 und dem Außenring 2 sind kugelförmige Wälzkörper 3 angeordnet, die zwischen dem Innenring 1 und dem Außenring 2 abrollen können. Die kugelförmigen Wälzkörper 3 sind beispielsweise aus Keramik gefertigt und sind somit nichtmagnetisch.

Das in der Fig. 1 dargestellte Wälzlager W₁ ist zur Lagerung einer in der Fig. 3 dargestellten Patientenliege 30 eines Kernspintomographen KT vorgesehen. Um eine der Verwendung des in der Fig. 1 dargestellten Wälzlagers W₁ entsprechende Tragzahl des Wälzlagers W₁ zu erreichen, sind die kugelförmigen Wälzkörper 3 relativ groß, was sich u.a. negativ auf die Herstellungskosten des Wälzlagers W₁ auswirkt.

Die Fig. 2 zeigt ein Schnittbild eines erfindungsgemäßen Wälzlagers W₂ für einen Kernspintoiriographen. Das in der Fig. 2 gezeigte Wälzlager W₂ ist im Falle des vorliegenden Ausführungsbeispieles ein zweireihiges Kugellager. Das erfindungsgemäße Wälzlager W₂ weist einen Innenring 21 und einen Außenring 22 auf, zwischen denen kugelförmige Wälzkörper 23 abrollen können. Der Innenring 21, der Außenring 22 und die Wälzkörper 23 sind im Falle des vorliegenden Ausführungsbeispieles aus einem magnetischen und gehärteten Stahl gefertigt. Außerdem ist der Außenring 22 des Wälzlagers W₂ in einen nichtmagnetischen Ring 24 gepresst, welcher im Falle des vorliegenden Ausführungsbeispieles aus einem nichtmagnetischen Stahl gefertigt ist.

Das in der Fig. 2 dargestellte Wälzlager W₂ ist für den Einbau in einen Kernspintomographen KT anstelle des in der Fig. 1 gezeigten Wälzlagers W₁ vorgesehen. Deshalb weisen die Innenringe 1 und 21 der in den Fig. 1 und 2 gezeigten Wälzlager W₁ und W₂ im Falle des vorliegenden Ausführungsbeispieles wenigstens im Wesentlichen dieselben Innendurchmesser d₁ bzw. d₂₁ auf. Des weiteren weist der nichtmagnetische Ring 24 des in der Fig. 2 dargestellten Wälzlagers W₂ einen Außendurchmesser D₂₄ auf, der wenigstens im Wesentlichen gleich dem Außendurchmesser D₂ des in der Fig. 1 dargestellten Außenringes 2 des Wälzlagers W₁ ist. Im Falle des vorliegenden Ausführungsbeispieles sind der Außendurchmesser D₂ des Außenringes 2 und der Außendurchmesser D₂₄ des nichtmagnetischen Ringes 24 62mm.

Magnetische Wälzlager mit magnetischen und gehärteten Wälzkörpern, Innen- und Außenringen weisen eine höhere Tragzahl auf als nichtmagnetische Wälzlager mit keramischen Wälzkörpern. Somit können die kugelförmigen Wälzkörper 23 des erfindungsgemäßen Wälzlagers W₂ deutlich kleiner ausgeführt werden als die nichtmagnetischen kugelförmigen Wälzkörper 3 des in der Fig. 1 gezeigten konventionellen nichtmagnetischen Wälzlagers W₁. Im Falle der vorliegenden Ausführungsbeispiele weisen die kugelförmigen Wälzlagers 3 des nichtmagnetischen Wälzlagers W₁ einen Durchmesser von 12mm auf, wobei die kugelförmigen magnetischen Wälzlager 23 des erfindungsgemäßen Wälzlagers W₂ nur einen Durchmesser von 5mm aufweisen.

Des weiteren ist im Falle des vorliegenden Ausführungsbeispieles vorgesehen, dass der Außendurchmesser D₂₄ des nichtmagnetischen Ringes 24 doppelt so groß ist als der Außendurchmesser D₂₂ des Außenringes 22 des in der Fig. 2 gezeigten Wälzlagers W₂. Folglich haben die magnetischen Komponenten des in der Fig. 2 gezeigten Wälzlagers W₂ nur eine relativ geringe räumliche Ausdehnung, so dass das von den magnetischen Komponenten des Wälzlagers W₂ erzeugte magnetische Feld im Gegensatz zu einem magnetischen Feld, welches von einem Kernspintomographen für eine Untersuchung erzeugt wird, klein ist und sich somit wenn, dann kaum störend auf den Betrieb des Kernspintomographen auswirkt.

Die Fig. 3 zeigt grob schematisch einen Kernspintomographen KT, für den das in der Fig. 2 gezeigte erfindungsgemäße Wälzlager W₂ verwendet wird. Im Falle des vorliegenden Ausführungsbeispieles ist vorgesehen, das in der Fig. 2 gezeigte Wälzlager W₂ insbesondere für die Lagerung einer Patientenliege 30 des Kernspintomographen KT zu verwenden. Es sind aber auch andere Verwendungszwecke für einen Kernspintomographen KT denkbar.

Außerdem müssen der Innenring 21 und der Außenring 22 des in der Fig. 2 dargestellten Wälzlagers W₂ nicht notwendigerweise magnetisch sein. Es sind auch nichtmagnetische Innenringe 21 und/oder Außenringe 22 möglich.

Die kugelförmigen Wälzkörper 23 müssen nicht notwendigerweise aus magnetischem und gehärtetem Stahl hergestellt sein. Sie können auch aus anderen magnetischen Materialien hergestellt sein.

Der nichtmagnetische Ring 24 kann auch andere als nichtmagnetischen Stahl aufweisende Materialien umfassen, solange diese Materialien nichtmagnetisch sind. Insbesondere können auch nichtmagnetisches Messing und/oder nichtmagnetisches Kupfer verwendet werden.

Das erfindungsgemäße Wälzlager W₂ muss nicht notwendigerweise ein zweireihiges Kugellager sein. Es sind auch andere Kugellager oder Wälzlager mit nicht-kugelförmigen Wälzkörpern, beispielsweise Zylinderrollen, Nadeln, Kegel oder Tonnenrollen, möglich.

Die obengenannten Abmessungen des erfindungsgemäßen Wälzlagers W₂ und das Größenverhältnis zwischen dem Außendurchmesser D₂₄ des nichtmagnetischen Ringes 24 und dem Außendurchmesser D₂₂ des Außenringes 22 sind ebenfalls nur exemplarisch zu verstehen.

## Patentansprüche

1. Kernspintomograph (KT) mit einem Wälzlager (W₂), **dadurch gekennzeichnet, dass** das Wälzlager (W₂) magnetische Wälzkörper (23) aufweist.

2. Kernspintomograph (KT) nach Anspruch 1, wobei die magnetischen Wälzkörper (23) des Wälzlagers (W₂) zwischen einem Innenring (21) und einem Außenring (22) abrollen, und der Außenring (22) von einem nichtmagnetischen Ring (24) umgeben ist.

3. Kernspintomograph (KT) nach Anspruch 1 oder 2, wobei der nichtmagnetische Ring (24) nichtmagnetischen Stahl, nichtmagnetisches Messing und/oder nichtmagnetisches Kupfer aufweist.

4. Kernspintomograph (KT) nach einem der vorhergehenden Ansprüche, wobei der Außenring (22) in den nichtmagnetischen Ring (24) eingepresst ist.

5. Kernspintomograph (KT) nach einem der vorhergehenden Ansprüche, wobei der Innenring (21) und/oder der Außenring (22) magnetisch sind.

6. Kernspintomograph (KT) nach einem der vorhergehenden Ansprüche, wobei der Außendurchmesser (D24) des nichtmagnetischen Ringes (24) wenigstens 1,5-mal größer ist als der Außendurchmesser (D₂₂) des Außenringes (22).

7. Kernspintomograph (KT) nach einem der vorhergehenden Ansprüche, wobei das Wälzlager ein Kugellager (W₂) ist.

8. Kernspintomograph (KT) nach einem der vorhergehenden Ansprüche, wobei das Wälzlager ein zweireihiges Kugellager (W2) ist.

9. Kernspintomograph (KT)nach einem der Ansprüche 2 bis 8, wobei die Wälzkörper (23) kugelförmig sind und einen Durchmesser zwischen 3mm und 8mm aufweisen und der nichtmagnetische Ring (24) einen Außendurchmesser (D₂₄) zwischen 55mm und 65mm aufweist.

## Claims

1. NMR tomograph (KT) having an antifriction bearing (W₂), **characterized in that** the antifriction bearing (W₂) has magnetic rolling members (23).

2. NMR tomograph (KT) according to Claim 1, in which the magnetic rolling members (23) of the antifriction bearing (W₂) roll along between an inner ring (21) and an outer ring (22), and the outer ring (22) is surrounded by a nonmagnetic ring (24).

3. NMR tomograph (KT) according to Claim 1 or 2, in which the nonmagnetic ring (24) has nonmagnetic steel, nonmagnetic brass and/or nonmagnetic copper.

4. NMR tomograph (KT) according to one of the preceding claims, in which the outer ring (22) is pressed into the nonmagnetic ring (24).

5. NMR tomograph (KT) according to one of the preceding claims, in which the inner ring (21) and/or the outer ring (22) are magnetic.

6. NMR tomograph (KT) according to one of the preceding claims, in which the outside diameter (D₂₄) of the nonmagnetic ring (24) is at least 1.5 times larger than the outside diameter (D₂₂) of the outer ring (22).

7. NMR tomograph (KT) according to one of the preceding claims, in which the antifriction bearing is a ball bearing (W₂).

8. NMR tomograph (KT) according to one of the preceding claims, in which the antifriction bearing is a double-row ball bearing (W₂).

9. NMR tomograph (KT) according to one of Claims 2 to 8, in which the rolling members (23) are spherical and have a diameter of between 3 mm and 8 mm, and the nonmagnetic ring (24) has an outside diameter (D₂₄) of between 55 mm and 65 mm.

## Revendications

1. Tomographe (KT) à résonance magnétique nucléaire ayant un palier (W2) de roulement, **caractérisé en ce que** le palier (W2) de roulement a des corps (23) de roulement magnétiques.

2. Tomographe (KT) à résonance magnétique nucléaire suivant la revendication 1, dans lequel les corps (23) de roulement magnétiques du palier (W2) magnétique roulent entre une bague (21) intérieure et une bague (22) extérieure et la bague (22) extérieure est entourée d'une bague (24) amagnétique.

3. Tomographe (KT) à résonance magnétique nucléaire suivant la revendication 1 ou 2, dans lequel la bague (24) amagnétique comporte de l'acier amagnétique, du laiton amagnétique et/ou du cuivre amagnétique.

4. Tomographe (KT) à résonance magnétique nucléaire suivant l'une des revendications précédentes, dans lequel la bague (22) extérieure est enfoncée dans la bague (24) amagnétique.

5. Tomographe (KT) à résonance magnétique nucléaire suivant l'une des revendications précédentes, dans lequel la bague (21) intérieure et/ou la bague (22) extérieure sont magnétiques.

6. Tomographe (KT) à résonance magnétique nucléaire suivant l'une des revendications précédentes, dans lequel le diamètre (D24) extérieur de la bague (24) amagnétique est plus grand d'au moins 1,5 fois le diamètre (D22) extérieur de la bague (22) extérieure.

7. Tomographe (KT) à résonance magnétique nucléaire suivant l'une des revendications précédentes, dans lequel le palier à roulement est un palier (W2) à billes.

8. Tomographe (KT) à résonance magnétique nucléaire suivant l'une des revendications précédentes, dans lequel le palier à roulement est un palier (W2) à billes à deux rangées.

9. Tomographe (KT) à résonance magnétique nucléaire suivant l'une des revendications 2 à 8, dans lequel les paliers (23) à roulement sont de forme sphérique et ont un diamètre compris entre 3 mm et 8 mm et la bague (24) amagnétique a un diamètre (D24) extérieur compris entre 55 mm et 65 mm.
